# EUROPEAN PATENT APPLICATION

(11) **EP 4 607 594 A1**
(43) Date of publication of application: **27.08.2025**
(21) Application number: 22966556.7
(22) Date of filing: 23.11.2022
(51) Int. Cl.: H01L 27/12, H01L 25/075, H01L 23/00

(54) **SELF-ASSEMBLED SUBSTRATE AND DISPLAY DEVICE**

(71) Applicant: LG Electronics Inc., Yeongdeungpo-gu Seoul 07336 (KR); LG Display Co., Ltd., Seoul, 07336 (KR)
(72) Inventor: PARK, Changseo, Seoul 06772 (KR); KIM, Gunho, Seoul 06772 (KR); KIM, Myoungsoo, Seoul 06772 (KR); KIM, Jungsub, Seoul 06772 (KR)
(74) Representative: Vossius & Partner Patentanwälte Rechtsanwälte mbB
(86) International application number: PCT/KR2022/018566
(87) International publication number: WO 2024/111695

(57) **Abstract**

The self-assembled substrate may include a substrate, a first assembly wiring on the substrate, a second assembly wiring on the substrate, a partition wall having an assembly hole on the first assembly wiring and the second assembly wiring, a first non-uniform layer having a first uneven structure on the partition wall, and a dielectric capping layer having a second uneven structure on the partition wall. The second uneven structure may have a shape corresponding to a shape of the first uneven structure.

## Description

### [Technical Field]

The embodiment relates to a self-assembled substrate and a display device.

### [Background Art]

A large-area display includes a liquid crystal display (LCD), an OLED display, and a micro-LED display.

The micro-LED display is a display that uses micro-LEDs, which are semiconductor light-emitting elements with a diameter or cross-sectional area of 100*µ*m or less, as display elements.

Since the micro-LED display uses the micro-LEDs, which are semiconductor light-emitting elements, as display elements, it has excellent performance in many characteristics such as contrast ratio, response speed, color reproducibility, viewing angle, brightness, resolution, lifespan, luminous efficiency, and luminance.

In particular, the micro-LED display has the advantage of being able to freely adjust the size or resolution by separating and combining the screens in a modular manner, and the advantage of being able to implement a flexible display.

However, since a large micro-LED display requires millions of micro-LEDs, there is a technical problem in quickly and accurately transferring micro-LEDs to a display panel.

Recently developed transfer technologies include the pick and place process, the laser lift-off method, or the self-assembly method.

Among these, the self-assembly method is a method in which semiconductor light-emitting elements find their assembly positions in a fluid on their own, which is advantageous for implementing large-screen display devices.

The following two methods are being developed to implement large-screen display devices using the self-assembly method.

In the first method, there is a method in which semiconductor light-emitting elements are assembled on an interposer substrate using the self-assembly method, and then transferred onto a backplane substrate.

In the second method, there is a method in which semiconductor light-emitting elements are directly self-assembled on the backplane substrate using the self-assembly method without the interposer substrate.

Both the first method and the second method have a problem in that the semiconductor light-emitting element is adsorbed on a self-assembled substrate, i.e., the interposer substrate or the backplane substrate, during the self-assembly process. Due to complex factors such as the van der Waals force or surface tension acting between the semiconductor light-emitting element and the self-assembled substrate, the semiconductor light-emitting element is not assembled in the target region, for example, the assembly hole, but is adsorbed in a region other than the assembly hole.

The semiconductor light-emitting element adsorbed on the self-assembled substrate in this way has a problem in that it causes disconnection or short circuiting of the electrode wiring during electrical connection by the post-process, resulting in lighting defects or display defects.

### [Disclosure]

### [Technical Problem]

An object of the embodiment is to solve the foregoing and other problems.

Another object of the embodiment is to provide a self-assembled substrate capable of preventing adsorption defects of the semiconductor light-emitting element onto a region other than the assembly hole.

In addition, another object of the embodiment is to provide a self-assembled substrate capable of preventing lighting defects or display defects caused by adsorption defects of the semiconductor light-emitting element.

The technical problems of the embodiments are not limited to those described in this item and comprise those that may be understood through the description of the invention.

### [Technical Solution]

In order to achieve the above or other objects, according to one aspect of the embodiment, a self-assembled substrate comprises: a substrate; a first assembly wiring on the substrate; a second assembly wiring on the substrate; a partition wall having an assembly hole on the first assembly wiring and the second assembly wiring; a first non-uniform layer having a first uneven structure on the partition wall; and a dielectric capping layer having a second uneven structure on the partition wall; wherein the second uneven structure may have a shape corresponding to a shape of the first uneven structure.

The dielectric capping layer may be a super-hydrophilic surface-modified layer. The dielectric capping layer may be a protective layer. The dielectric capping layer may be an external light-scattering layer.

The first non-uniform layer may comprise a plurality of bumps, and the plurality of bumps may be disposed on an upper surface of the partition wall.

A size of the bump may be smaller than a size of a semiconductor light-emitting element. A spacing between the bumps may be smaller than a size of the semiconductor light-emitting element.

A size of each of the plurality of bumps or a spacing between the plurality of bumps may be different depending on a separation distance from the assembly hole. A size of the bump located closer to the assembly hole may be greater than a size of the bump located farther from the assembly hole. A spacing between the bumps located closer to the assembly hole may be smaller than a spacing between the bumps located farther from the assembly hole.

The dielectric camping layer may be disposed on an upper surface of the partition wall excluding the assembly hole. The dielectric capping layer may be disposed on an inner side of the assembly hole.

The self-assembled substrate may comprise a second non-uniform layer having a third uneven structure on an upper surface of each of the plurality of bumps.

The second non-uniform layer may be disposed on an upper surface of the partition wall between the plurality of bumps. The third uneven structure may be a nanotexture.

The self-assembled substrate may be an interposer substrate or a backplane substrate.

According to another aspect of the embodiment, a display device may be manufactured using the self-assembled substrate.

### [Advantageous Effects]

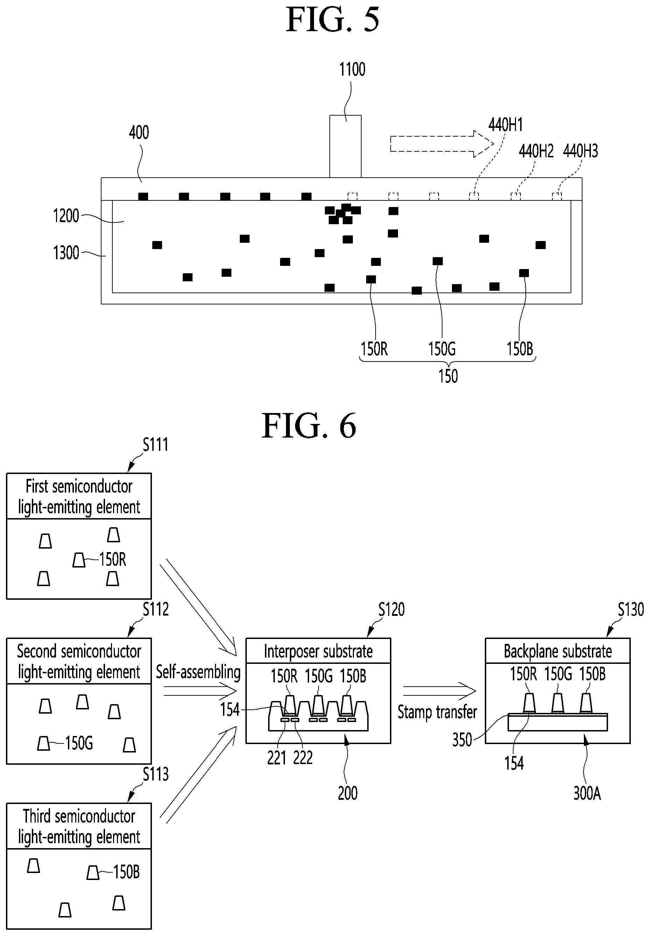

According to the embodiment, as illustrated in FIGS. 6 to 12, the self-assembled substrate 401 may be an interposer substrate 200 or a backplane substrate 300A to 300C. The interposer substrate 200 may be a substrate that aligns a plurality of semiconductor light-emitting elements 150R, 150G, and 150B in pixel units before being transferred onto the backplane substrate 300A to 300C. The backplane substrate 300A to 300C may be a substrate on which a plurality of semiconductor light-emitting elements 150R, 150G, and 150B are transferred in pixel units and then electrical connections are formed to manufacture a display device.

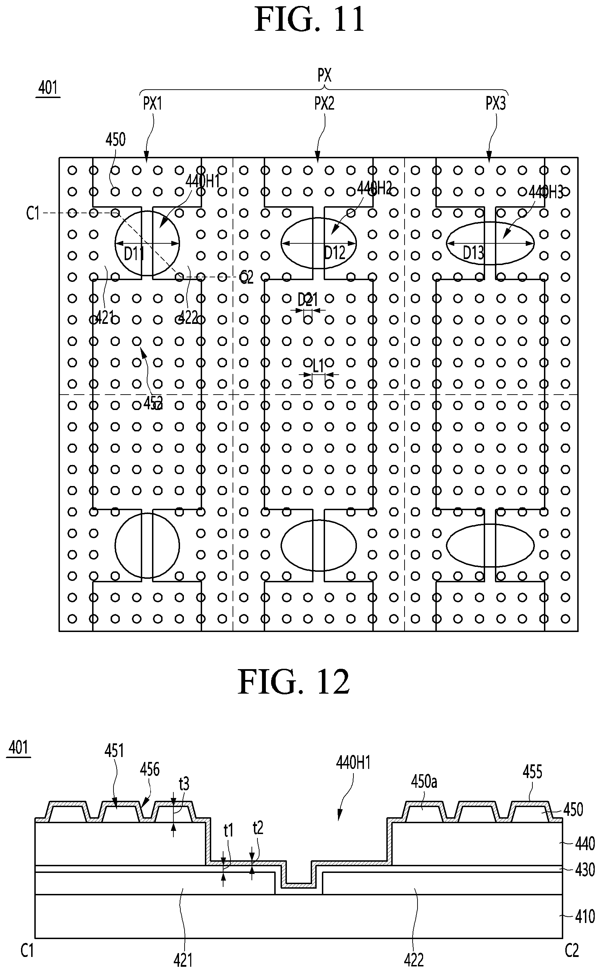

As illustrated in FIGS. 11 and 12, the self-assembled substrate 401 may comprise a first non-uniform layer 450 having a first uneven structure 451 disposed on a partition wall 440, and a dielectric capping layer 455 having a second uneven structure 456.

The dielectric capping layer 455 may be a super-hydrophilic surface-modified layer, a protective layer, or an external light-scattering layer.

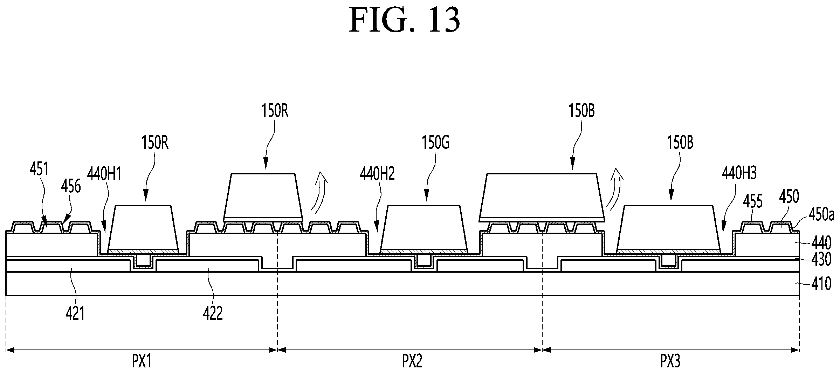

When the dielectric capping layer 455 is used as a super-hydrophilic surface-modified layer, as illustrated in FIG. 13, a plurality of semiconductor light-emitting elements 150R, 150G, and 150B moving by the magnet 1100 during self-assembly are not adsorbed onto the partition wall 440 by using the dielectric capping layer 455, thereby preventing defects caused by adsorption, such as disconnection or short-circuiting of the electrode wiring during post-processing, and also preventing an increase in cost caused by such adsorption.

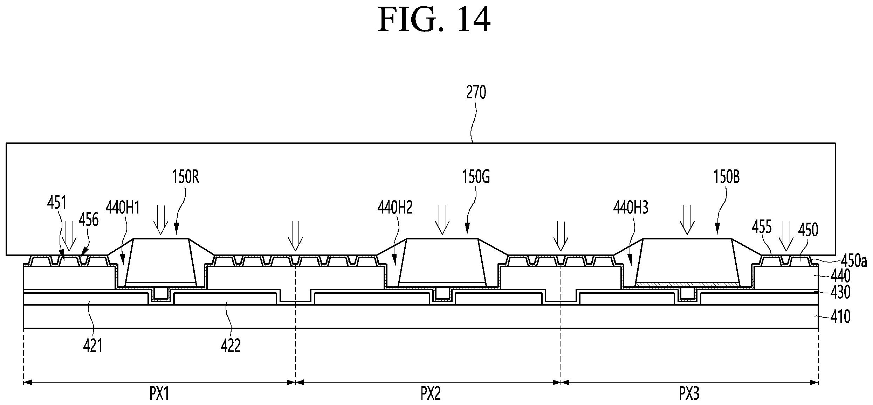

When the dielectric capping layer 455 is used as a protective layer, as illustrated in FIG. 14, even if the transfer substrate 270 is pressed onto the self-assembled substrate 401, the stress caused by the transfer substrate 270 is blocked by the dielectric capping layer 455, thereby protecting the partition wall 440.

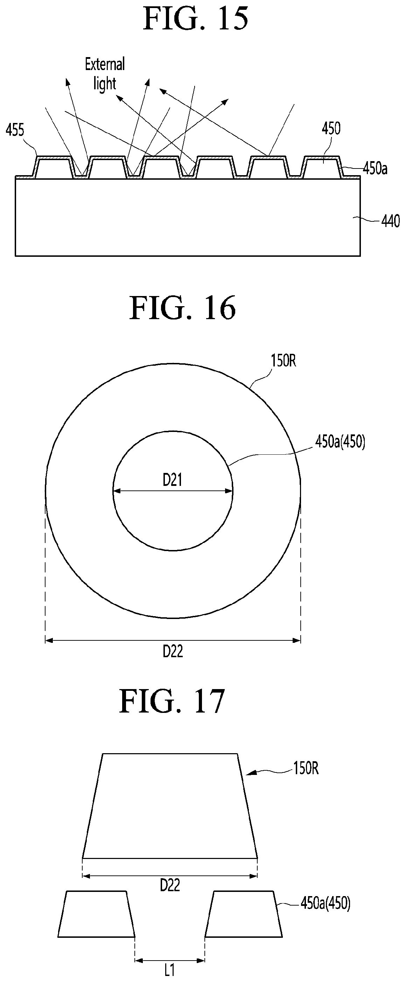

When the dielectric capping layer 455 is used as an external light-scattering layer, as illustrated in FIG. 15, as the external light is scattered or diffusely reflected by the dielectric capping layer 455, the scattered light does not travel toward the user's eyes, thereby preventing glare.

Meanwhile, in the embodiment, the size of each of the plurality of bumps 450a or the spacing between the plurality of bumps 450a may be different depending on the separation distance from the assembly hole.

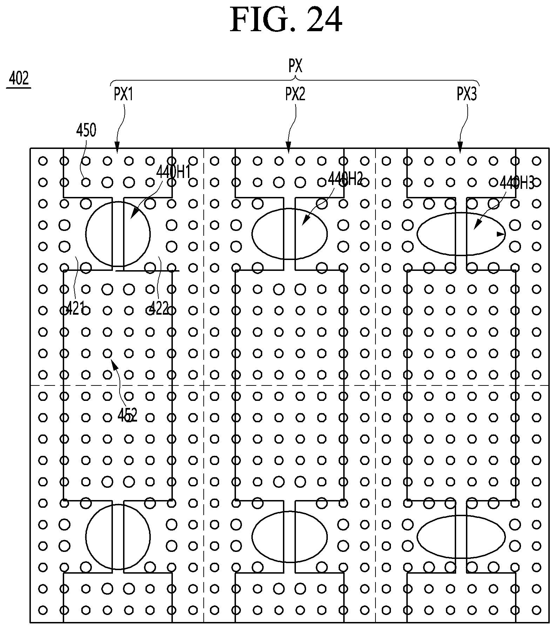

For example, as shown in FIG. 24, by making the size D21 of the bump 450a located closer to the assembly hole 440H1 to 440H3 greater than that of the bump 450a located farther from the assembly hole 440H1 to 440H3, the number of semiconductor light-emitting devices adsorbed near the assembly hole 440H1 to 440H3 may be increased. Accordingly, at least one or more semiconductor light-emitting device, adsorbed near the assembly hole 440H1 to 440H3 due to the movement of a plurality of semiconductor light-emitting devices 150R, 150G, and 150B having surrounding cluster units, may be detached due to a collision and may be then assembled into the adjacent assembly hole 440H1 to 440H3, thus increasing the assembly rate.

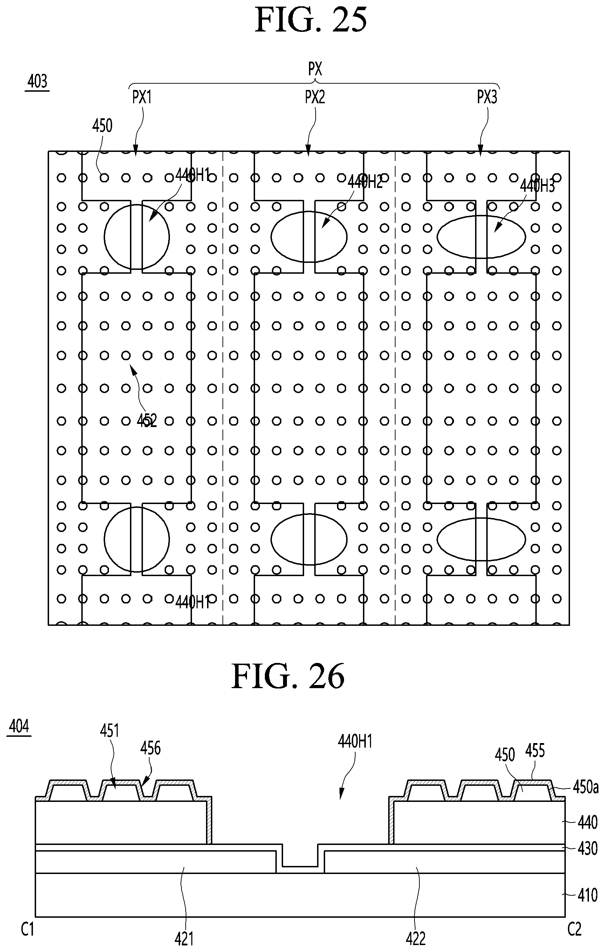

For example, as illustrated in FIG. 25, since the spacing L1 between the bumps 450a located close to the assembly holes 440H1 to 440H3 is smaller than the spacing L1 between the bumps 450a located farther from the assembly holes 440H1 to 440H3, the number of semiconductor light-emitting elements adsorbed near the assembly holes 440H1 to 440H3 may be increased. Accordingly, at least one or more semiconductor light-emitting device, adsorbed near the assembly hole 440H1 to 440H3 due to the movement of a plurality of semiconductor light-emitting devices 150R, 150G, and 150B having surrounding cluster units, may be detached due to a collision and may be then assembled into the adjacent assembly hole 440H1 to 440H3, thus increasing the assembly rate.

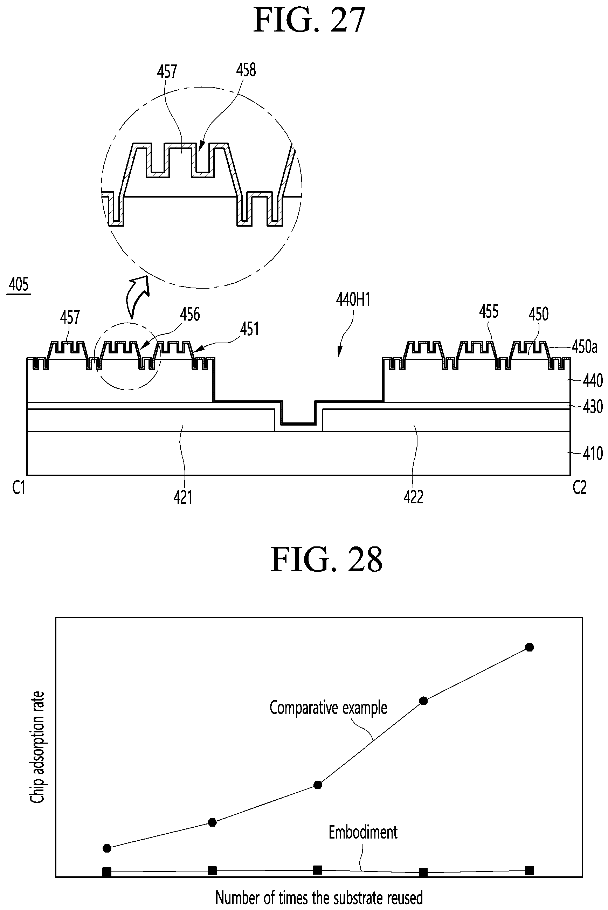

Meanwhile, as illustrated in FIG. 27, in the embodiment, the second non-uniform layer 457 having the third uneven structure 458 may be disposed on an upper surface of each of the plurality of bumps 450a, thereby further reducing the possibility of adsorption on the partition wall 440. Thus, lighting defects due to disconnection or short circuiting of the electrode wiring caused by adsorption defects can be prevented.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 illustrates a living room of a house in which a display device according to an embodiment is disposed.
FIG. 2 is a block diagram schematically showing a display device according to an embodiment.
FIG. 3 is a circuit diagram showing an example of a pixel of FIG. 2.
FIG. 4 is an enlarged view of a first panel region in the display device of FIG. 1.
FIG. 5 illustrates a process of assembling a semiconductor light-emitting element according to an embodiment into a self-assembled substrate by a self-assembly method.
FIG. 6 is a drawing explaining a first method for manufacturing a display device according to an embodiment.
FIG. 7 is a cross-sectional view illustrating a transfer method using a transfer substrate in a first method for manufacturing a display device according to an embodiment.
FIG. 8 is a drawing explaining a second method for manufacturing a display device according to an embodiment.
FIG. 9 is a cross-sectional view illustrating a direct transfer method using a self-assembled substrate in a second method for manufacturing a display device according to an embodiment.
FIG. 10 is a drawing explaining a third method for manufacturing a display device according to an embodiment.
FIG. 11 is a plan view illustrating a self-assembled substrate according to a first embodiment.
FIG. 12 is a cross-sectional view taken along the C1-C2 line of the self-assembled substrate according to the first embodiment.
FIG. 13 illustrates a state in which a semiconductor light-emitting element is not adsorbed on a self-assembled substrate during self-assembly.
FIG. 14 illustrates a state in which a partition wall of a backplane substrate is protected even when a transfer substrate is pressurized by a transfer process.
FIG. 15 illustrates a state in which external light is scattered in implementing display.
FIG. 16 illustrates a size of a bump of a first non-uniform layer of an embodiment and a size of a semiconductor light-emitting element.
FIG. 17 illustrates a spacing between bumps of first non-uniform layers of an embodiment and a size of a semiconductor light-emitting element.
FIGS. 18 to 20 illustrate a first method for manufacturing a self-assembled substrate according to the first embodiment.
FIGS. 21 to 23 illustrate a second method for manufacturing a self-assembled substrate according to the first embodiment.
FIG. 24 is a plan view illustrating a self-assembled substrate according to a second embodiment.
FIG. 25 is a plan view illustrating a self-assembled substrate according to a third embodiment.
FIG. 26 is a cross-sectional view illustrating a self-assembled substrate according to a fourth embodiment.
FIG. 27 is a cross-sectional view illustrating a self-assembled substrate according to a fifth embodiment.
FIG. 28 shows the adsorption rates in each of the comparative example and the embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

The display device described in this specification may comprise a TV, a signage, a mobile terminal such as a mobile phone or a smart phone, a computer display such as a laptop or a desktop, a head-up display (HUD) for an automobile, a backlight unit for a display, a display for extended reality (XR) such as AR, VR, and mixed reality (MR), a light source, etc. However, the configuration according to the embodiment described in this specification may be equally applied to a device capable of displaying, even if it is a new product type developed in the future.

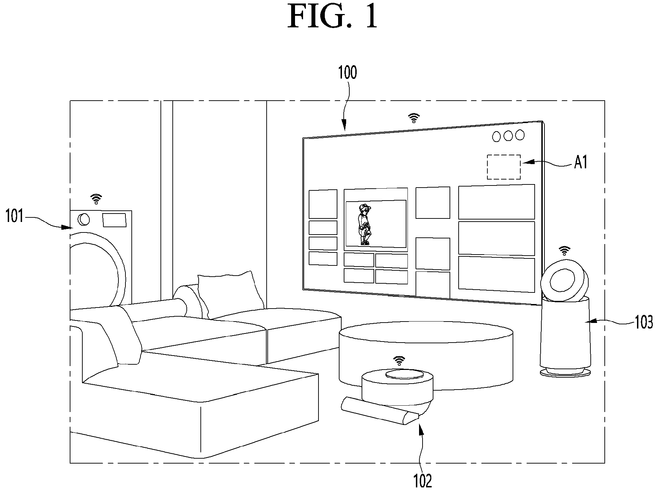

FIG. 1 illustrates a living room of a house in which a display device according to an embodiment is disposed.

Referring to FIG. 1, the display device 100 according to the embodiment may display the status of various electronic products such as a washing machine 101, a robot vacuum cleaner 102, and an air purifier 103, and may communicate with each electronic product based on IoT and control each electronic product based on user setting data.

The display device 100 according to the embodiment may comprise a flexible display manufactured on a thin and flexible substrate. The flexible display may be bent or rolled like paper while maintaining the characteristics of a conventional flat display.

In a flexible display, visual information may be implemented by independently controlling the light emission of unit pixels disposed in a matrix form. A unit pixel means a minimum unit for implementing one color. The unit pixel of the flexible display may be implemented by a light-emitting element. In an embodiment, the light-emitting element may be a micro-LED or a nano-LED, but is not limited thereto.

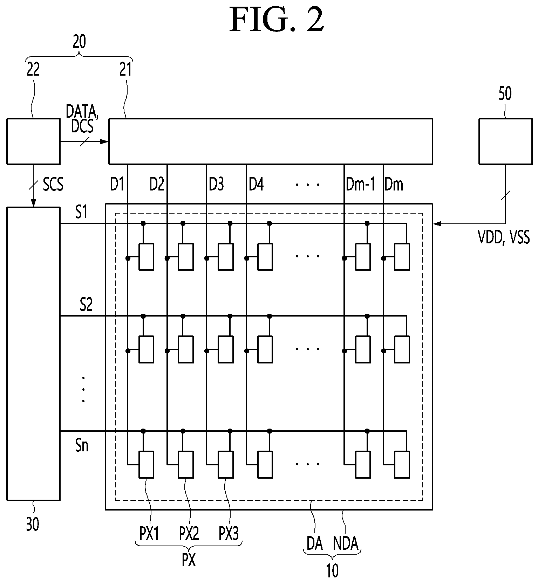

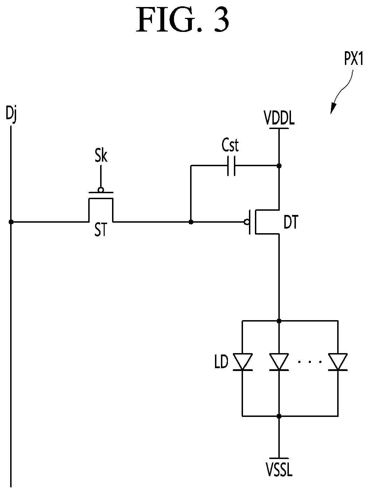

FIG. 2 is a block diagram schematically showing a display device according to an embodiment, and FIG. 3 is a circuit diagram showing an example of a pixel of FIG. 2.

Referring to FIG. 2 and FIG. 3, the display device according to an embodiment may comprise a display panel 10, a driving circuit 20, a scan driving unit 30, and a power supply circuit 50.

The display device 100 of the embodiment may drive the light-emitting element in an active matrix (AM) manner or a passive matrix (PM) manner.

The driving circuit 20 may comprise a data driving unit 21 and a timing control unit 22.

The display panel 10 may be formed in a rectangular shape, but is not limited thereto. That is, the display panel 10 may be formed in a circular or elliptical shape. At least one side of the display panel 10 may be formed to be bent at a predetermined curvature.

The display panel may comprise a display region DA. The display region DA is a region where pixels PX are formed to display an image. The display panel may comprise a non-display region NDA. The non-display region NDA may be a region excluding the display region DA.

As an example, the display region DA and the non-display region NDA may be defined on the same surface. For example, the non-display region NDA may surround the display region DA on the same surface together with the display region DA, but is not limited thereto.

As another example, although not illustrated in the drawing, the display region DA and the non-display region NDA may be defined on different surfaces. For example, the display region DA may be defined on the upper surface of the substrate, and the non-display region NDA may be defined on the lower surface of the substrate. For example, the non-display region NDA may be defined on the overall region or a part of the lower surface of the substrate.

Meanwhile, although the drawing illustrates that the display region DA and the non-display region NDA are divided, the display region DA and the non-display region NDA may not be divided. That is, only the display region DA may exist on the upper surface of the substrate, and the non-display region NDA may not exist. In other words, the overall region of the upper surface of the substrate may be the display region DA where the image is displayed, and the bezel region, which is the non-display region NDA, may not exist.

The display panel 10 may comprise data lines (D1 to Dm, where m is an integer greater than or equal to 2), scan lines (S1 to Sn, where n is an integer greater than or equal to 2) intersecting the data lines D1 to Dm, a high-potential voltage line VDDL supplied with a high-potential voltage VDD, a low-potential voltage line VSSL supplied with a low-potential voltage VSS, and pixels PX connected to the data lines D1 to Dm and the scan lines S1 to Sn.

Each of the pixels PX may comprise a first subpixel PX1, a second subpixel PX2, and a third subpixel PX3. The first subpixel PX1 may emit a first color light of a first main wavelength, the second subpixel PX2 may emit a second color light of a second main wavelength, and the third subpixel PX3 may emit a third color light of a third main wavelength. The first color light may be red light, the second color light may be green light, and the third color light may be blue light, but the present invention is not limited thereto. In addition, although FIG. 2 exemplifies that each of the pixels PX comprises three subpixels, the present invention is not limited thereto. That is, each of the pixels PX may comprise four or more subpixels.

Each of the first subpixel PX1, the second subpixel PX2, and the third subpixel PX3 may be connected to at least one of the data lines D1 to Dm, at least one of the scan lines S1 to Sn, and a high-potential voltage line VDDL. The first subpixel PX1 may comprise light-emitting elements LD, a plurality of transistors for supplying current to the light-emitting elements LD, and at least one capacitor Cst, as illustrated in FIG. 3.

Although not illustrated in the drawing, each of the first subpixel PX1, the second subpixel PX2, and the third subpixel PX3 may comprise only one light-emitting element LD and at least one capacitor Cst.

Each of the light-emitting elements LD may be a semiconductor light-emitting diode comprising a first electrode 154, a plurality of conductive semiconductor layers, and a second electrode 155. Here, the first electrode 154 may be an anode electrode, and the second electrode 155 may be a cathode electrode, but is not limited thereto.

The light-emitting element LD may be one of a lateral-type light-emitting element, a flip-chip type light-emitting element, and a vertical-type light-emitting element.

The plurality of transistors may comprise a driving transistor DT for supplying current to the light-emitting elements LD, and a scan transistor ST for supplying a data voltage to a gate electrode of the driving transistor DT, as illustrated in FIG. 3. The driving transistor DT may comprise a gate electrode connected to a source electrode of the scan transistor ST, a source electrode connected to a high-potential voltage line VDDL to which a high-potential voltage VDD is applied, and a drain electrode connected to the first electrodes 154 of the light-emitting elements LD. The scan transistor ST may comprise a gate electrode connected to a scan line (Sk, where k is an integer satisfying 1 ≤ k ≤ n), a source electrode connected to the gate electrode of the driving transistor DT, and a drain electrode connected to a data line (Dj, where j is an integer satisfying 1 ≤ j ≤ m).

A capacitor Cst may be formed between the gate electrode and the source electrode of the driving transistor DT. The storage capacitor Cst charges a difference value between the gate voltage and the source voltage of the driving transistor DT.

The driving transistor DT and the scan transistor ST may be formed of a thin film transistor. In addition, in FIG. 3, the driving transistor DT and the scan transistor ST are described mainly as being formed as P-type metal oxide semiconductor field effect transistors (MOSFETs), but the present invention is not limited thereto. The driving transistor DT and the scan transistor ST may also be formed as N-type MOSFETs. In this instance, the positions of the source electrode and the drain electrode of each of the driving transistor DT and the scan transistors ST may be changed.

In addition, in FIG. 3, the first subpixel PX1, the second subpixel PX2, and the third subpixel PX3 are exemplified as comprising 2T1C (2 Transistor - 1 capacitor) having one driving transistor DT, one scan transistor ST, and one capacitor Cst, but the present invention is not limited thereto. The first subpixel PX1, the second subpixel PX2, and the third subpixel PX3 may each comprise a plurality of scan transistors ST and a plurality of capacitors Cst.

The second subpixel PX2 and the third subpixel PX3 may be expressed in substantially the same circuit diagram as the first subpixel PX1, so that detailed descriptions thereof will be omitted.

The driving circuit 20 outputs signals and voltages for driving the display panel 10. To this end, the driving circuit 20 may comprise a data driving unit 21 and a timing control unit 22.

The data driving unit 21 receives digital video data DATA and a source control signal DCS from the timing control unit 22. The data driving unit 21 converts the digital video data DATA into analog data voltages according to the source control signal DCS and supplies the converted data to the data lines D1 to Dm of the display panel 10.

The timing control unit 22 receives digital video data DATA and timing signals from a host system. The host system may be an application processor of a smartphone or tablet PC, a monitor, a system-on-chip of a TV, etc.

The timing control unit 22 generates control signals for controlling the operation timing of the data driving unit 21 and the scan driving unit 30. The control signals may comprise a source control signal DCS for controlling the operation timing of the data driving unit 21 and a scan control signal SCS for controlling the operation timing of the scan driving unit 30.

The driving circuit 20 may be disposed in a non-display region NDA provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited thereto. For example, the driving circuit 20 may be mounted on a circuit board (not illustrated) other than the display panel 10.

The data driving unit 21 may be mounted on the display panel 10 using a chip on glass (COG) method, a chip on plastic (COP) method, or an ultrasonic bonding method, and the timing control unit 22 may be mounted on a circuit board.

The scan driving unit 30 receives a scan control signal SCS from the timing control unit 22. The scan driving unit 30 generates scan signals according to the scan control signal SCS and supplies them to the scan lines S1 to Sn of the display panel 10. The scan driving unit 30 may be formed in a non-display region NDA of the display panel 10 comprising a plurality of transistors. Alternatively, the scan driving unit 30 may be formed as an integrated circuit, in which case it may be mounted on a gate flexible film attached to the other side of the display panel 10.

The power supply circuit 50 may generate voltages necessary for driving the display panel 10 from a main power applied from a system board and supply them to the display panel 10. For example, the power supply circuit 50 may generate a high-potential voltage VDD and a low-potential voltage VSS for driving the light-emitting elements LD of the display panel 10 from the main power supply and supply them to the high-potential voltage line VDDL and the low-potential voltage line VSSL of the display panel 10. In addition, the power supply circuit 50 may generate and supply driving voltages for driving the driving circuit 20 and the scan driving unit 30 from the main power supply.

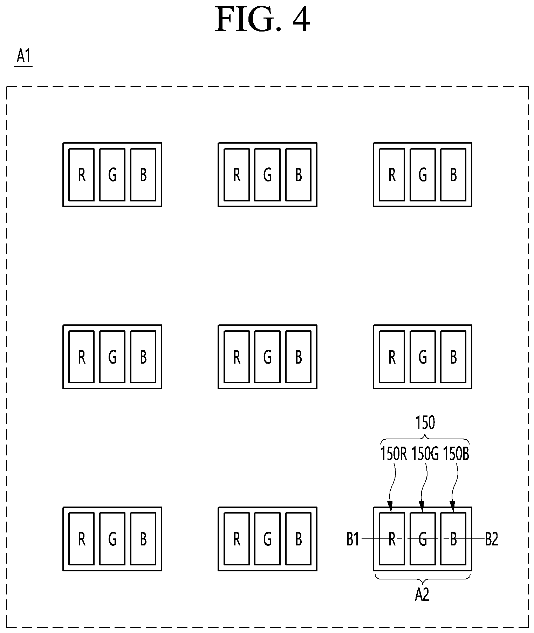

FIG. 4 is an enlarged view of the first panel region in the display device of FIG. 3.

Referring to FIG. 4, the display device 100 of the embodiment may be manufactured by mechanically and electrically connecting a plurality of panel regions such as the first panel region A1 by tiling.

The first panel region A1 may comprise a plurality of semiconductor light-emitting elements 150 disposed for each unit pixel (PX of FIG. 2).

Hereinafter, various embodiments for solving the above-described problem will be described with reference to FIGS. 5 to 28. Any description omitted below may be easily understood from the descriptions described above with respect to FIGS. 1 to 4 and the corresponding drawings.

In the embodiment, the self-assembled substrate 401 to 405 may be a substrate for assembling semiconductor light-emitting elements using a self-assembly method developed by the applicants. The self-assembled substrate 401 to 405 may be used as an interposer substrate 200 or a backplane substrate 300A to 300C.

The interposer substrate 200 may be a substrate for assembling a semiconductor light-emitting element corresponding to each of a plurality of subpixels of a plurality of pixels using a self-assembly method. Thereafter, the assembled semiconductor light-emitting elements on the interposer substrate 200 may be transferred onto the backplane substrate 300A to 300C.

The backplane substrate 300A to 300C may be a substrate for assembling a semiconductor light-emitting element corresponding to each of a plurality of subpixels of a plurality of pixels using a self-assembly method. Thereafter, a display device may be manufactured through a post-process for forming an electrical connection of each of the semiconductor light-emitting elements assembled on the backplane substrate 300A to 300C.

First, a self-assembly method according to an embodiment will be described.

FIG. 5 illustrates a process of assembling a semiconductor light-emitting element according to an embodiment into a self-assembled substrate by a self-assembly method.

As illustrated in FIG. 5, a semiconductor light-emitting element 150 may be put into a chamber 1300 filled with a fluid 1200. The fluid 1200 may be water such as ultrapure water, but is not limited thereto. The chamber 1300 may be named a tank, a container, a vessel, etc. The semiconductor light-emitting element 150 may comprise a first semiconductor light-emitting element 150R, a second semiconductor light-emitting element 150G, and a third semiconductor light-emitting element 150B. In this instance, the first semiconductor light-emitting element 150R to the third semiconductor light-emitting element 150B may be put into the fluid 1200, or only one of the first semiconductor light-emitting element 150R to the third semiconductor light-emitting element 150B may be put into the fluid 1200. The semiconductor light-emitting element 150 may comprise an electrode. The electrode may comprise a magnetic layer. The magnetic layer may be magnetized by the magnet 1100, so that the semiconductor light-emitting element 150 may move toward the magnet 1100.

The self-assembled substrate 400 may be fixed to an upper side of the chamber 1300. Although not illustrated in the drawing, the self-assembled substrate 400 may also be fixed to a lower side of the chamber 1300.

The magnet 1100 may be moved in a preset direction at the rear of the self-assembled substrate 400. The magnet 1100 may be moved in the x-axis, y-axis, and z-direction. The magnet 1100 may be moved in a rotational movement or a zigzag movement. For example, the magnet 1100 may be moved parallel to the surface of the self-assembled substrate 400. The magnet 1100 may be located in contact with or near the upper surface of the self-assembled substrate 400. In this instance, the magnetic field of the magnet 1100 may affect the fluid 1200. Accordingly, the semiconductor light-emitting elements 150 in the fluid 1200 may be moved toward the magnet 1100 and along the inner side of the self-assembled substrate 400. In this instance, the semiconductor light-emitting elements 150 may pass through the assembly holes 440H1 to 440H3 of the self-assembled substrate 400. At this time, the semiconductor light-emitting elements 150 may be assembled into the corresponding assembly holes 440H1 to 440H3 by a dielectric electrophoretic force (hereinafter referred to as DEP force) formed by the assembly wirings of the self-assembled substrate 400.

Referring to FIGS. 6 to 9 below, a display manufacturing process using the interposer substrate 200 will be described.

FIG. 6 is a drawing explaining a first method for manufacturing a display device according to an embodiment.

As illustrated in FIG. 6, a plurality of first semiconductor light-emitting elements 150R may be manufactured (S111), a plurality of second semiconductor light-emitting elements 150G may be manufactured (S112), and a plurality of third semiconductor light-emitting elements 150B may be manufactured (S113).

Specifically, the plurality of first semiconductor light-emitting elements 150R, the plurality of second semiconductor light-emitting elements 150G, and the plurality of third semiconductor light-emitting elements 150B may be independently manufactured. Each of the first semiconductor light-emitting element 150R, the second semiconductor light-emitting element 150G, and the third semiconductor light-emitting element 150B may emit light of different colors. For example, the first semiconductor light-emitting element 150R may comprise a red semiconductor light-emitting element, the second semiconductor light-emitting element 150G may comprise a green semiconductor light-emitting element, and the third semiconductor light-emitting element 150B may comprise a blue semiconductor light-emitting element.

In an embodiment, the first semiconductor light-emitting element 150R, the second semiconductor light-emitting element 150G, and the third semiconductor light-emitting element 150B may each be a vertical-type semiconductor light-emitting element, but is not limited thereto. In the vertical-type semiconductor light-emitting element, an electrode may be provided on an upper side and/or a lower side of the light-emitting layer.

For example, a series of semiconductor processes may be performed on a first wafer, and the plurality of first semiconductor light-emitting elements 150R may be manufactured. For example, a series of semiconductor processes may be performed on a second wafer, and the plurality of second semiconductor light-emitting elements 150G may be manufactured. For example, a series of semiconductor processes may be performed on a third wafer, and the plurality of third semiconductor light-emitting elements 150B may be manufactured.

Meanwhile, the plurality of first semiconductor light-emitting elements 150R, the plurality of second semiconductor light-emitting elements 150G, and the plurality of third semiconductor light-emitting elements 150B may be assembled on an interposer substrate 200 by a self-assembly method (S120).

That is, the plurality of first semiconductor light-emitting elements 150R, the plurality of second semiconductor light-emitting elements 150G, and the plurality of third semiconductor light-emitting elements 150B are put into a fluid 1200, and after an interposer substrate 200 is located in the fluid 1200, the plurality of first semiconductor light-emitting elements 150R, the plurality of second semiconductor light-emitting elements 150G, and the plurality of third semiconductor light-emitting elements 150B may be assembled on the interposer substrate 200 using a magnetic field and an electric field. The magnet 1100 may generate a magnetic field, may be located on an outer side of the interposer substrate 200, and may move in parallel with the interposer substrate 200. The electric field may be formed by an AC voltage applied to a pair of assembly wirings provided on the interposer substrate 200. A DEP force may be formed by this electric field. In order to apply an AC voltage, a first assembly wiring 221 and a second assembly wiring 222 may be provided on the interposer substrate 200.

For example, the plurality of first semiconductor light-emitting elements 150R, the plurality of second semiconductor light-emitting elements 150G, and the plurality of third semiconductor light-emitting elements 150B may be moved to desired positions on the interposer substrate 200 by a magnetic field. the plurality of first semiconductor light-emitting elements 150R, the plurality of second semiconductor light-emitting elements 150G, and the plurality of third semiconductor light-emitting elements 150B may be assembled to the desired positions on the interposer substrate 200 by a DEP force.

Meanwhile, the plurality of first semiconductor light-emitting elements 150R, the plurality of second semiconductor light-emitting elements 150G, and the plurality of third semiconductor light-emitting elements 150B on an interposer substrate 200 may be transferred onto a backplane substrate 300A using a stamp transfer method (S130).

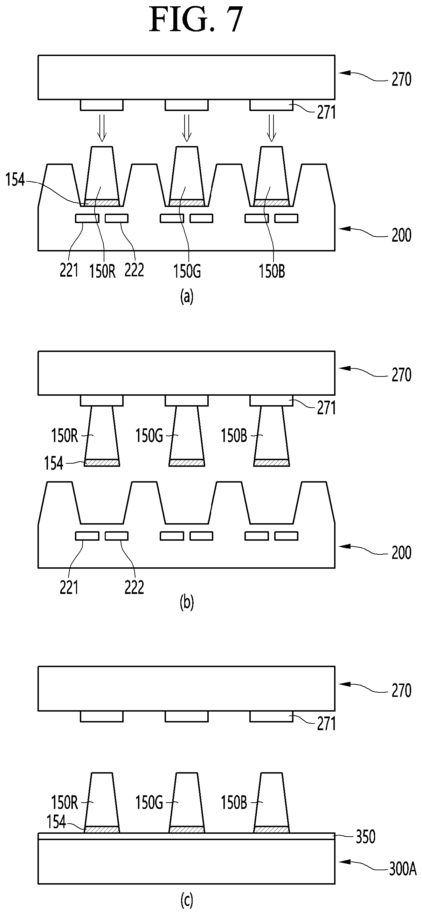

As illustrated in FIG. 7A, a transfer substrate 270 having a plurality of stamps 271 may be located on the interposer substrate 200 and then aligned with the interposer substrate 200. Thereafter, the interposer substrate 200 may be lowered and pressurized and then raised, so that the plurality of first semiconductor light-emitting elements 150R, the plurality of second semiconductor light-emitting elements 150G, and the plurality of third semiconductor light-emitting elements 150B on the interposer substrate 200 may be transferred onto the transfer substrate 270. For example, one semiconductor light-emitting element or a plurality of semiconductor light-emitting elements 150R, 150G, and 150B may be adhered to each of the plurality of stamps 271.

As illustrated in FIG. 7B, the transfer substrate 270 may be moved onto the backplane substrate 300A and aligned with the backplane substrate 300A.

As illustrated in FIG. 7C, the transfer substrate 270 may be lowered, pressurized, and then raised, so that the plurality of first semiconductor light-emitting elements 150R, the plurality of second semiconductor light-emitting elements 150G, and the plurality of third semiconductor light-emitting elements 150B on the transfer substrate 270 may be transferred to the backplane substrate 300A.

A tack layer 350 may be disposed on the backplane substrate 300A, and a tackiness of the tack layer 350 may be greater than a tackiness of the stamp 271 of the transfer substrate 270. Accordingly, when the transfer substrate 270 is pressed onto the backplane substrate 300A and then separated, the plurality of first semiconductor light-emitting elements 150R, the plurality of second semiconductor light-emitting elements 150G, and the plurality of third semiconductor light-emitting elements 150B may be transferred to the tack layer 350 of the backplane substrate 300A having greater tackiness.

As described above, the first semiconductor light-emitting elements 150R to the third semiconductor light-emitting elements 150B that emit light of different colors may be first aligned to form pixels on the interposer substrate 200, and then the first semiconductor light-emitting elements 150R to the third semiconductor light-emitting elements 150B aligned on the interposer substrate 200 may be transferred onto corresponding pixels on the backplane substrate 300A using the transfer substrate 270.

Depending on the size of the transfer substrate 270, the first semiconductor light-emitting elements 150R to the third semiconductor light-emitting elements 150B corresponding to a large number of pixels may be simultaneously transferred onto the backplane substrate 300A at one time. For example, when 1,000 pixels are defined on the backplane substrate 300A and the transfer substrate 270 has a size corresponding to 500 pixels, the first semiconductor light-emitting element 150R to the third semiconductor light-emitting element 150B may be transferred to each of the pixels of the backplane substrate 300A through two transfer processes. That is, after the first semiconductor light-emitting element 150R to the third semiconductor light-emitting element 150B included in the 500 pixels are transferred onto the backplane substrate 300A through a first transfer process, the first semiconductor light-emitting element 150R to the third semiconductor light-emitting element 150B included in the remaining 500 pixels may be transferred onto the backplane substrate 300A through a second transfer process. Thereafter, the display device may be manufactured by connecting electrode wiring to the upper side of each of the first semiconductor light-emitting element 150R to the third semiconductor light-emitting element 150B.

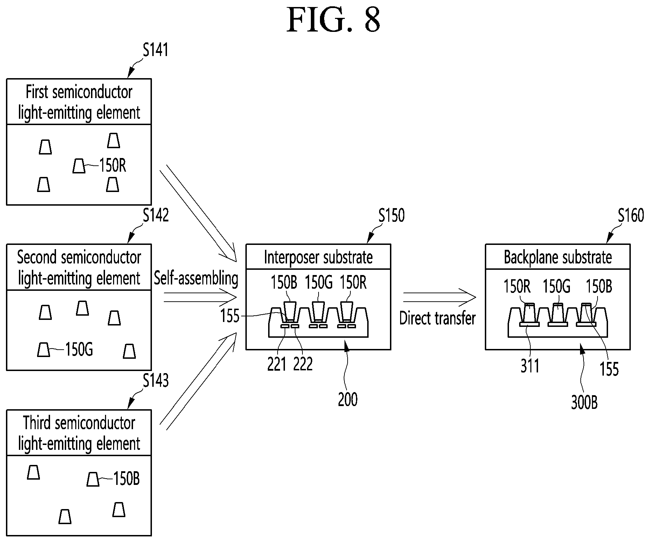

FIG. 8 is a drawing explaining a second method for manufacturing a display device according to an embodiment.

Since S141 to S143 in FIG. 8 are the same as S111 to S113 in FIG. 7, detailed descriptions are omitted.

A plurality of first semiconductor light-emitting elements 150R, the plurality of second semiconductor light-emitting elements 150G, and the plurality of third semiconductor light-emitting elements 150B may be assembled on an interposer substrate 200 by a self-assembly process (S150).

Thereafter, unlike FIG. 7, as illustrated in FIG. 8, transfer may be directly performed onto a backplane substrate 300B using the interposer substrate 200. That is, the interposer substrate 200 may be flipped over and then moved onto the backplane substrate 300B. Thereafter, the interposer substrate 200 may be lowered and pressed onto the backplane substrate 300B while heat is applied, so that the first semiconductor light-emitting element 150R to the third semiconductor light-emitting element 150B on the interposer substrate 200 may be transferred onto the backplane substrate 300B. In addition, by applying heat, the first semiconductor light-emitting element 150R to the third semiconductor light-emitting element 150B may be bonded to the electrode wirings 311 of the backplane substrate 300B, respectively. The electrode wiring 311 may be, for example, a cathode electrode, but is not limited thereto. In this instance, an anode electrode (not illustrated) as a common electrode may be commonly connected to the upper side of each of the first semiconductor light-emitting element 150R to the third semiconductor light-emitting element 150B.

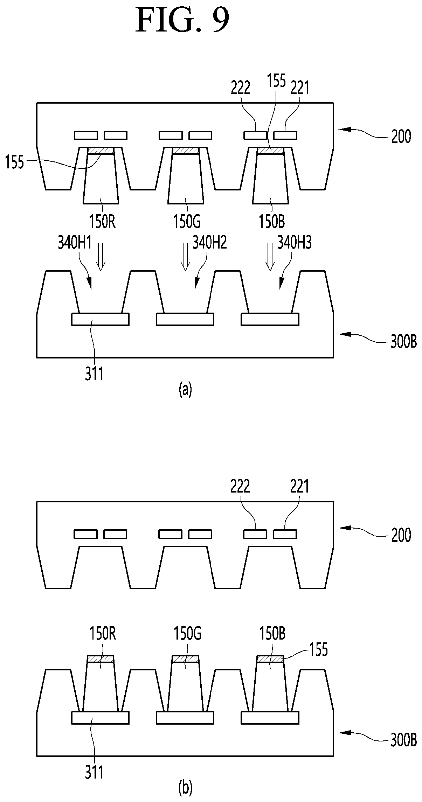

As illustrated in FIG. 9A, the interposer substrate 200 may be flipped over and then moved onto the backplane substrate 300B.

Thereafter, the interposer substrate 200 may be lowered, pressurized, and then raised, so that the first semiconductor light-emitting element 150R to the third semiconductor light-emitting element 150B on the interposer substrate 200 may be transferred onto the backplane substrate 300B.

An electrode wiring 311, i.e., a cathode electrode, may be provided on the backplane substrate 300B. In this instance, the backplane substrate 300B may be pressed by the interposer substrate 200 and may be heated at the same time. The electrodes provided on the lower side of each of the first semiconductor light-emitting element 150R to the third semiconductor light-emitting element 150B may be electrically connected to the electrode wiring 311 by the heat. The electrode may be melted by heat as solder, and the electrode may be joined to the electrode wiring 311 as solder. After that, another electrode wiring, i.e., an anode electrode, may be commonly connected on the upper side of each of the first semiconductor light-emitting elements 150R to the third semiconductor light-emitting elements 150B, so that a display device may be manufactured.

As described above, since the interposer substrate 200 functions as a transfer substrate 270, the transfer substrate 270 illustrated in FIG. 7 may be omitted. In addition, since the transfer process and the bonding process are performed simultaneously, the overall process may be simplified and the processing time may be significantly reduced.

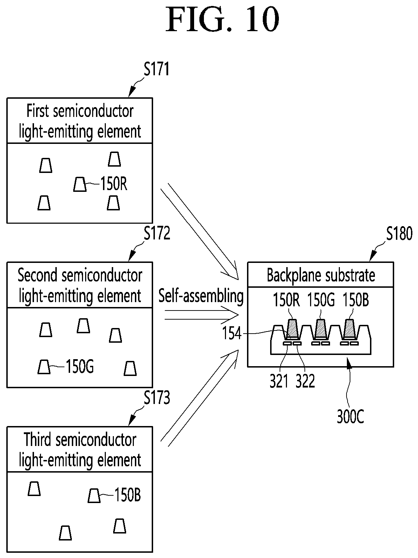

Referring to FIG. 10 below, a display manufacturing process using the backplane substrate 300C will be described.

FIG. 10 is a drawing explaining a third method for manufacturing a display device according to an embodiment.

In FIG. 10, S171 to S173 are the same as S111 to S113 of FIG. 7, so that detailed descriptions thereof will be omitted.

A plurality of first semiconductor light-emitting elements 150R, the plurality of second semiconductor light-emitting elements 150G, and the plurality of third semiconductor light-emitting elements 150B may be assembled on a backplane substrate 300C by a self-assembly process (S180). Thereafter, a display device may be manufactured by electrically connecting each of the first semiconductor light-emitting elements 150R to the third semiconductor light-emitting elements 150B assembled on the backplane substrate by a post-process.

Hereinafter, various embodiments of the self-assembled substrate will be described with reference to FIGS. 11 to 28.

In the following description, the self-assembled substrate may be an interposer substrate (200 of FIGS. 6 to 9) or a backplane substrate (300C of FIG. 10).

### [First embodiment]

FIG. 11 is a plan view illustrating a self-assembled substrate according to a first embodiment. FIG. 12 is a cross-sectional view taken along the C1-C2 line of the self-assembled substrate according to the first embodiment.

Referring to FIG. 11 and FIG. 12, the self-assembled substrate 401 according to the first embodiment may comprise a substrate 410, a first assembly wiring 421, a second assembly wiring 422, a partition wall 440, a first non-uniform layer 450, and a dielectric capping layer 455.

The substrate 410 may be a support substrate for supporting components of the self-assembled substrate 401 according to the first embodiment, that is, a plurality of first assembly wirings 421, a plurality of second assembly wirings 422, a partition wall 440, etc. The substrate 410 may be made of a plastic material, a ceramic material, glass, etc., but is not limited thereto.

A plurality of pixels PX may be defined on the substrate 410. Each of the plurality of pixels PX may comprise a plurality of subpixels PX1 to PX3. For example, when the substrate 410 is a base substrate for an interposer substrate, the size of a pixel on the substrate 410 may be the same as the size of a pixel defined on the backplane substrate. At this time, the pixel defined on the backplane substrate may be a unit pixel for a display. For example, when the substrate 410 is a base substrate for a backplane substrate, the pixel on the substrate 410 itself may be a unit pixel for a display.

The first assembly wiring 421 may be disposed on the substrate 410. The second assembly wiring 422 may be disposed on the substrate 410. The first assembly wiring 421 and the second assembly wiring 422 may be disposed on the same layer, that is, on the substrate 410. Although not illustrated in the drawing, the first assembly wiring 421 and the second assembly wiring 422 may be disposed on different layers, and the first assembly wiring 421 and the second assembly wiring 422 may be insulated by an insulating layer 430. When the first assembly wiring 421 and the second assembly wiring 422 are disposed on different layers, the spacing between the first assembly wiring 421 and the second assembly wiring 422 may be minimized, thereby enabling an arrangement of semiconductor light-emitting elements having ultra-high resolution.

The first assembly wiring 421 and the second assembly wiring 422 may be disposed in each of the subpixels PX1 to PX3 of the plurality of pixels PX. For example, the first subpixel PX1, the second subpixel PX2, and the third subpixel PX3 may each comprise the first assembly wiring 421 and the second assembly wiring 422. The first assembly wiring 421 and the second assembly wiring 422 may generate a DEP force so that the corresponding semiconductor light-emitting elements are assembled in the corresponding subpixels PX1 to PX3.

For example, a first semiconductor light-emitting element 150R may be assembled on a first subpixel PX1 by the DEP force generated by the first assembly wiring 421 and the second assembly wiring 422 on a first subpixel PX1. For example, a second semiconductor light-emitting element 150G may be assembled on a second subpixel PX2 by the DEP force generated by the first assembly wiring 421 and the second assembly wiring 422 on a second subpixel PX2. For example, a third semiconductor light-emitting element 150B may be assembled on a third subpixel PX3 by the DEP force generated by the first assembly wiring 421 and the second assembly wiring 422 on a third subpixel PX3.

A partition wall 440 may be disposed on the first assembly wiring 421 and the second assembly wiring 422. The partition wall 440 may have a plurality of assembly holes 440H1 to 440H3. The plurality of assembly holes 440H1 to 440H3 may allow the first semiconductor light-emitting element 150R to the third semiconductor light-emitting element 150B to be easily assembled and prevented from being easily separated, respectively. The assembly holes 440H1 to 440H3 may be formed through the upper and lower surfaces of the partition wall 440.

The plurality of assembly holes 440H1 to 440H3 may have different shapes and/or sizes. For example, the first assembly hole 340H1 may have a circular shape, and the second assembly hole 340H2 and the third assembly hole 340H3 may each have an elliptical shape. The size of the elliptical major axis of the third assembly hole 340H3 may be greater than the size of the elliptical major axis of the second assembly hole 340H2, and the size of the elliptical minor axis of the third assembly hole 340H3 may be smaller than the size of the elliptical minor axis of the second assembly hole 340H2. For example, the diameter of the circle of the first assembly hole 340H1 may be D11, the length of the elliptical major axis of the second assembly hole 340H2 may be D12, and the length of the elliptical major axis of the third assembly hole 340H3 may be D13. In this instance, the length D13 of the elliptical major axis of the third assembly hole 340H3 may be greater than the length D12 of the elliptical major axis of the second assembly hole 340H2, and the length D12 of the elliptical major axis of the second assembly hole 340H2 may be greater than the diameter D11 of the first assembly hole 340H1.

In this way, the fact that the first assembly hole 340H1 to the third assembly hole 340H3 are different means that the exclusivity of the first assembly hole 340H1 to the third assembly hole 340H3 is different, and due to this different exclusivity, incorrect assembly of the first semiconductor light-emitting element 150R to the third semiconductor light-emitting element 150B can be prevented. That is, the first semiconductor light-emitting element 150R may be correctly assembled into the first assembly hole 340H1 without incorrect assembly occurring in the second assembly hole 340H2 or the third assembly hole 340H3. Similarly, the second semiconductor light-emitting element 150G may be correctly assembled into the second assembly hole 340H2 without incorrect assembly occurring in the first assembly hole 340H1 or the third assembly hole 340H3.

The first non-uniform layer 450 may be disposed on the partition wall 440. The first non-uniform layer 450 may have a first uneven structure 451. The first non-uniform layer 450 may have a plurality of bumps 450a. The plurality of bumps 450a may be disposed on the partition wall 440. The bump 450a may be referred to as pattern. In the drawing, the bump 450a may be illustrated as circular, but other shapes are also possible. The plurality of bumps 450a may be spaced apart from each other. The bump may also be referred to as unevenness, pattern, protrusion, protrusion part, protrusion region, etc.

The first uneven structure 451 may be formed on the partition wall 440 by the plurality of bumps 450a and the separation space between the plurality of bumps 450a. An upper surface of the partition wall 440 may be exposed by the separation space.

As illustrated in FIG. 16, the size D21 of the bump 450a may be smaller than the size D22 of the semiconductor light-emitting element 150R, thereby reducing the overlapping area between the semiconductor light-emitting element 150R and the bump 450a, thereby preventing the semiconductor light-emitting element from being absorbed on the self-assembled substrate 401.

As illustrated in FIG. 17, the spacing L1 between the bumps 450a may be smaller than the size D22 of the semiconductor light-emitting element 150R, so that a defect in which the semiconductor light-emitting element is inserted between the bumps 450a and does not come off can be prevented
The dielectric capping layer 455 may be disposed on the partition wall 440. The dielectric capping layer 455 may be formed of a material having a permittivity. For example, the dielectric capping layer 455 may comprise an inorganic material such as SiOx, SiNx, etc.

The dielectric capping layer 455 may have a second uneven structure 456. At this time, the second uneven structure 456 may have a shape corresponding to a shape of the first uneven structure 451.

In an embodiment, the dielectric capping layer 455 may have a very thin thickness t2. For example, the thickness t2 of the dielectric capping layer 455 may be smaller than the thickness t1 of the insulating layer 430, which will be described later. For example, the thickness t2 of the dielectric capping layer 455 may be several nanometers to several tens of nanometers.

For example, the thickness t2 of the dielectric capping layer 455 may be smaller than the thickness t3 of the bump 450a. The dielectric capping layer 455 may be disposed on the upper surface of the partition wall 440. The dielectric capping layer 455 may be disposed on each of the plurality of bumps 450a of the first non-uniform layer 450. In this instance, the dielectric capping layer 455 may be disposed on an upper surface of the partition wall 440 and an upper surface of the bump 450a with a thickness t2 smaller than the thickness t3 of the bump 450a, so that the dielectric capping layer 455 may have a shape corresponding to a shape of the first uneven structure 451 of the first non-uniform layer 450.

In an embodiment, the dielectric capping layer 455 may have a complex variety of functions.

First, the dielectric capping layer 455 may be a super-hydrophilic surface-modified layer. Therefore, when the first semiconductor light-emitting element 150R to the third semiconductor light-emitting element 150B are assembled on the self-assembled substrate 401 according to the first embodiment by the self-assembly process, as illustrated in FIG. 13, the first semiconductor light-emitting element 150R to the third semiconductor light-emitting element 150B may not be adsorbed due to the dielectric capping layer 455.

For self-assembly, when the self-assembled substrate 401 according to the first embodiment is in contact with the fluid 1200 and self-assembly is performed, the first semiconductor light-emitting element 150R to the third semiconductor light-emitting element 150B may be moved by the magnet 1100. At this time, the first semiconductor light-emitting element 150R to the third semiconductor light-emitting element 150B may be attempted to be adsorbed onto the partition wall 440 by the van der Waals force or surface tension.

Since the dielectric capping layer 455 covering the partition wall 440 is a super-hydrophilic surface-modified layer, the adsorption of the first semiconductor light-emitting element 150R to the third semiconductor light-emitting element 150B may be hindered by the dielectric capping layer 455, so that the first semiconductor light-emitting element 150R to the third semiconductor light-emitting element 150B are not adsorbed onto the partition wall 440, thereby preventing defects due to adsorption, such as disconnection or short circuiting of electrode wiring due to a post-process, and also preventing an increase in cost due to adsorption. Here, the increase in cost may mean an increase in cost due to an increase in the number of semiconductor light-emitting elements wasted due to adsorption. That is, the semiconductor light-emitting elements wasted due to adsorption are discarded because they are not collected and cannot be reused, so that the cost may increase due to the waste of the semiconductor light-emitting element. Therefore, the increase in cost may be reduced as the adsorption on the partition wall 440 is reduced.

As illustrated in FIG. 28, the chip adsorption rate may be significantly reduced in the embodiment provided with the dielectric capping layer 455 compared to the comparative example without the dielectric capping layer 455. That is, in the comparative example, the chip adsorption rate increases according to the number of times the self-assembled substrate 401 is reused. In contrast, in the embodiment, it may be seen that the chip adsorption rate is constant and very low regardless of the number of times the self-assembled substrate 401 is reused.

Second, the dielectric capping layer 455 may be a protective layer. When the self-assembled substrate 401 according to the first embodiment is used as the interposer substrate 200, the transfer substrate 270 may be pressed against the interposer substrate 200 for the transfer process, as illustrated in FIGS. 6 and 7. In this instance, the partition wall 440 may be damaged by the stress caused by the pressing of the transfer substrate 270. However, in the embodiment, since the dielectric capping layer 455 covers the partition wall 440 and functions as a protective layer, as illustrated in FIG. 14, even if the transfer substrate 270 is pressed onto the self-assembled substrate 401 according to the first embodiment, the stress caused by the transfer substrate 270 is blocked by the dielectric capping layer 455, so that the partition wall 440 can be protected.

Third, the dielectric capping layer 455 may be an external light-scattering layer. Here, the external light may comprise not only natural light such as the sun, but also artificial light such as lighting. When the self-assembled substrate 401 according to the first embodiment is used as a backplane substrate, after the first semiconductor light-emitting element 150R to the third semiconductor light-emitting element 150B are assembled on the backplane substrate, electrical connection may be performed by a post-process, thereby manufacturing a display device.

The display device may be commercialized and used by a user. When a user watches an image through the display device in an outdoor environment with strong sunlight or under lighting, external light such as light from the sunlight or lighting may be reflected, causing problems such as glare. However, in the embodiment, since the dielectric capping layer 455 has the second uneven structure 456 as an external light-scattering layer, as illustrated in FIG. 15, the external light may be scattered or diffusely reflected by the dielectric capping layer 455, so that the scattered light does not travel toward the user's eyes, thereby preventing glare.

Meanwhile, the self-assembled substrate 401 according to the first embodiment may comprise an insulating layer 430. The insulating layer 430 may be disposed on the first assembly wiring 421 and the second assembly wiring 422 to protect the first assembly wiring 421 and the second assembly wiring 422. Since the fluid 1200 is filled in the assembly holes 440H1 to 440H3 during self-assembly in a state when the insulating layer 430 is omitted, the first assembly wiring 421 and the second assembly wiring 422 may be corroded by the fluid 1200. In addition, stress may be generated by the pressure applied during the transfer process, and this stress may cause the first assembly wiring 421 and the second assembly wiring 422 to be warped or disconnected. Accordingly, the above-described problem may be solved by disposing the insulating layer 430 on the first assembly wiring 421 and the second assembly wiring 422. In addition, the insulating layer 430 has a permittivity, and thus may contribute to the generation of DEP force.

Meanwhile, in the first embodiment, the dielectric capping layer 455 may be disposed not only on the partition wall 440 but also on the assembly holes 440H1 to 440H3.

Since the dielectric capping layer 455 is a super-hydrophilic surface-modified layer, it may be difficult for the semiconductor light-emitting element to be fixed within the assembly holes 440H1 to 440H3 during self-assembly. That is, the semiconductor light-emitting element assembled within the assembly holes 440H1 to 440H3 can be prevented from being adsorbed by the dielectric capping layer 455 within the assembly holes 440H1 to 440H3, and may fall out of the assembly holes 440H1 to 440H3. To solve this problem, the dielectric capping layer may not be disposed in the assembly holes 440H1 to 440H3. That is, the dielectric capping layer 455 may be disposed on the upper surface of the partition wall 440 excluding the assembly holes 440H1 to 440H3.

Meanwhile, when the semiconductor light-emitting elements assembled in the assembly holes 440H1 to 440H3 are sufficiently fixed by the DEP force, the dielectric capping layer 455 may be disposed in the assembly holes 440H1 to 440H3.

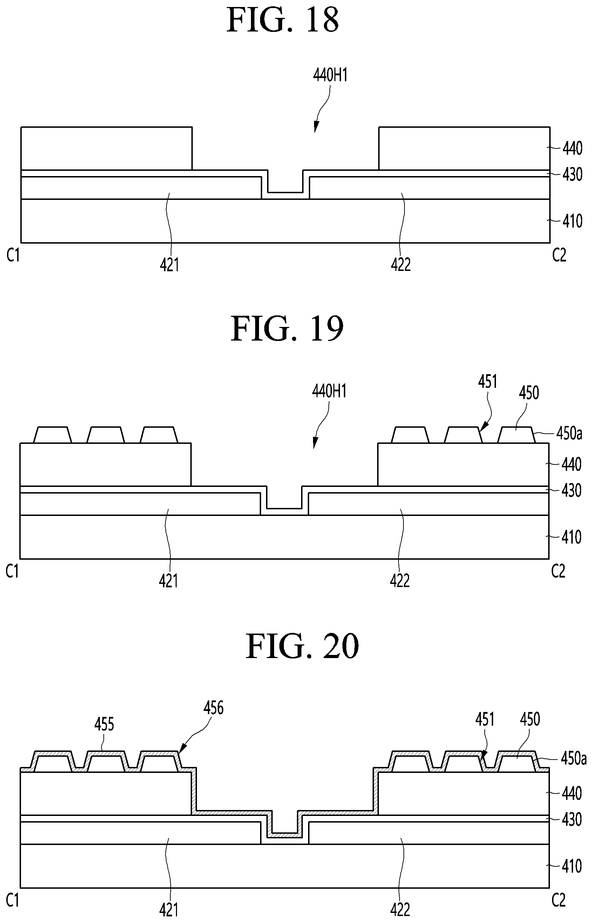

Hereinafter, a method for manufacturing a self-assembled substrate will be described with reference to FIGS. 18 to 20.

FIGS. 18 to 20 illustrate a first method for manufacturing a self-assembled substrate according to the first embodiment. FIGS. 18 to 20 illustrate a method for manufacturing a self-assembled substrate corresponding to the first subpixel PX1, but the method for manufacturing a self-assembled substrate corresponding to each of the second subpixel PX2 and the third subpixel PX3 is also the same as the method for manufacturing a self-assembled substrate corresponding to the first subpixel PX1 illustrated in FIGS. 18 to 20.

As illustrated in FIG. 18, a series of processes may be sequentially performed to form a partition wall 440 having an assembly hole 440H1. Here, the assembly hole 440H1 may be a first assembly hole 340H1.

Specifically, a substrate 410 may be provided first. A first assembly wiring 421 and a second assembly wiring 422 spaced apart from each other may be formed on the substrate 410. An insulating layer 430 may be formed on the first assembly wiring 421 and the second assembly wiring 422, and a partition wall 440 may be formed on the insulating layer 430. Thereafter, by removing a part of a region corresponding to the first subpixel PX1 among the partition walls 440, an assembly hole 440H1 may be formed. That is, a part of the partition wall 440 may be removed to expose the insulating layer 430, thereby forming an assembly hole 440H1. In this instance, a bottom surface of the assembly hole 440H1 may be the upper surface of the insulating layer 430.

As illustrated in FIG. 19, a first non-uniform layer 450 may be formed on the partition wall 440.

Specifically, first, a photosensitive film comprising a photosensitive polymer may be coated on the partition wall 440. Thereafter, the photosensitive film may be patterned through an exposure process and a development process, thereby forming a first non-uniform layer 450. The first non-uniform layer 450 may have a first uneven structure 451 comprising a plurality of bumps 450a. The first non-uniform layer 450 may be formed on the partition wall 440. That is, the exposure process and the development process may be performed, and the photosensitive film formed in the assembly hole 440H1 may be removed. As illustrated in FIG. 16 and FIG. 17, the size D21 of the bump 450a may be smaller than the size D22 of the semiconductor light-emitting element, and the spacing L1 between the bumps 450a may be smaller than the size D22 of the semiconductor light-emitting element 150R, so that the semiconductor light-emitting element 150R can be prevented from being inserted between the bumps 450a during later self-assembly.

The first non-uniform layer 450 may be made of the same material as the partition wall 440. For example, the first non-uniform layer 450 and the partition wall 440 may comprise a photosensitive polymer. However, the first non-uniform layer 450 and the partition wall 440 may be different layers. That is, the partition wall 440 may be formed, and the first non-uniform layer 450 may be independently formed on the partition wall 440.

As illustrated in FIG. 20, a dielectric capping layer 455 may be formed on the substrate 410. The dielectric capping layer 455 may be formed on the first non-uniform layer 450.

An inorganic film having a permittivity may be deposited on the substrate 410, thereby forming the dielectric capping layer 455. The dielectric capping layer 455 may be formed on the partition wall 440. The dielectric capping layer 455 may be formed in the assembly hole 440H1.

The thickness t2 of the dielectric capping layer 455 may be smaller than the thickness t1 of the insulating layer 430. For example, the thickness t2 of the dielectric capping layer 455 may be several nanometers to several tens of nanometers.

Since the thickness t2 of the dielectric capping layer 455 is smaller than the thickness t3 of the bump 450a, the dielectric capping layer 455 formed on the partition wall 440 may have a second uneven structure 456. The second uneven structure 456 may have a shape corresponding to a shape of the first uneven structure 451 of the first non-uniform layer 450.

Since the dielectric capping layer 455 is made of an inorganic material having a permittivity and has the second uneven structure 456, it may have functions as a super-hydrophilic surface-modified layer, a protective layer, an external light-scattering layer, etc., as described above.

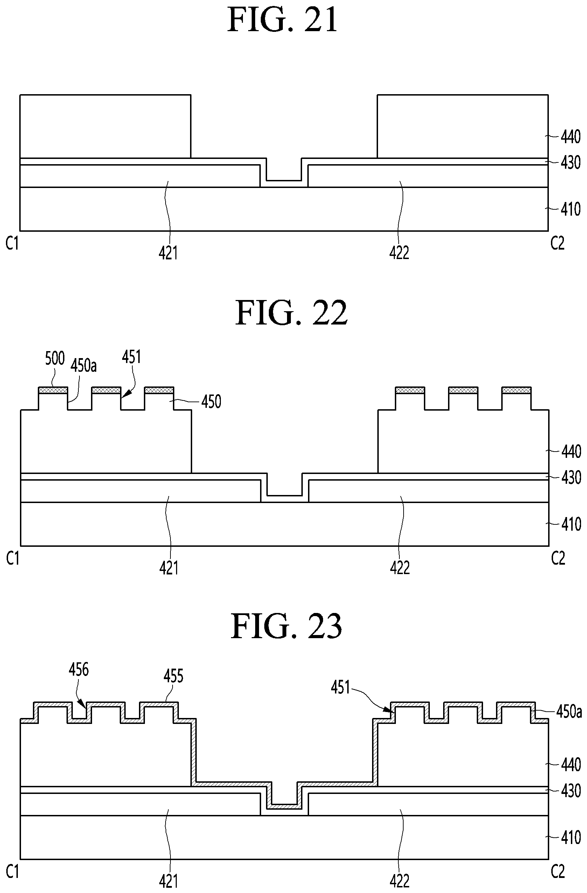

Meanwhile, a self-assembled substrate may be manufactured, unlike the manufacturing method illustrated in FIGS. 18 to 20. A second method for manufacturing a self-assembled substrate according to the first embodiment will be described with reference to FIGS. 21 to 23.

FIGS. 21 to 23 illustrate a second method for manufacturing a self-assembled substrate according to the first embodiment. FIGS. 21 to 23 illustrate a method for manufacturing a self-assembled substrate corresponding to the first subpixel PX1, but the method for manufacturing a self-assembled substrate corresponding to each of the second subpixel PX2 and the third subpixel PX3 is also the same as the method for manufacturing a self-assembled substrate corresponding to the first subpixel PX1 illustrated in FIGS. 21 to 23.

As illustrated in FIG. 21, a series of processes may be sequentially performed to form a first assembly wiring 421, a second assembly wiring 422, an insulating layer 430, and a partition wall 440 on a substrate 410. In addition, an assembly hole 440H1 may be formed in the partition wall 440. Here, the assembly hole 440H1 may be a first assembly hole 440H1.

Meanwhile, the thickness of the partition wall 440 may be greater than the thickness of the partition wall 440 illustrated in FIG. 18. This is because, as will be described later, the first non-uniform layer 450 may formed at the upper surface of the partition wall 440 as a part of the partition wall 440.

As illustrated in FIG. 22, a PR pattern 500 may be formed on the partition wall 440.

Specifically, a photosensitive film may be coated on the substrate 410. Thereafter, the photosensitive film may be patterned through an exposure and development process, thereby forming a PR pattern 500. The PR pattern 500 may not be formed on the assembly hole 440H1, but may be formed on the partition wall 440.

An etching process may be performed using the PR pattern 500 as a mask, so that parts of the upper surface of the partition wall 440 exposed between the PR patterns 500 may be removed, thereby forming a first non-uniform layer 450. Here, the etching process may be a dry etching process, but is not limited thereto. That is, the first non-uniform layer 450 may be formed on the upper surface of the partition wall 440 as a part of the partition wall 440. That is, at the upper surface of the partition wall 440, the upper surface of the partition wall 440 corresponding to the PR pattern 500 may be not etched, so that the first non-uniform layer 450 may be formed. In this instance, the upper surfaces of the partition wall 440 that is not etched by the PR pattern 500 may become bumps 450a. A first uneven structure 451 may be formed by these bumps 450a.

By performing a dry etching process, a side surface of the bump 450a may be formed as a plane perpendicular to the ground, but is not limited thereto.

As illustrated in FIG. 23, a dielectric capping layer 455 may be formed on the substrate 410. The dielectric capping layer 455 may be formed on the first non-uniform layer 450. The dielectric capping layer 455 may be formed not only on the partition wall 440 but also on the assembly hole 440H1, but is not limited thereto.

Since the dielectric capping layer 455 is made of an inorganic material having a permittivity and has a second uneven structure 456, it may have functions as a super-hydrophilic surface-modified layer, a protective layer, an external light-scattering layer, etc., as described above.

Meanwhile, in the first embodiment (FIGS. 11 to 23), the size D21 of each of the plurality of bumps 450a of the first non-uniform layer 450 or the spacing L1 between the bumps 450a are the same on the partition wall 440. However, by making the size D21 of each of the plurality of bumps 450a or the spacing L1 between the bumps 450a different according to the separation distance from the assembly holes 440H1 to 440H3, the adsorption force to the semiconductor light-emitting element may be varied (see FIGS. 24 and 25).

### [Second embodiment]

FIG. 24 is a plan view illustrating a self-assembled substrate according to a second embodiment.

As illustrated in FIG. 24, the size D21 of the bump 450a located close to the assembly holes 440H1 to 440H3 may be greater than the size D21 of the bump 450a located farther from the assembly holes 440H1 to 440H3.

The size D21 of the bump 450a located close to the assembly holes 440H1 to 440H3 may be relatively large. In this instance, when the semiconductor light-emitting element is located close to the assembly holes 440H1 to 440H3 during self-assembly, the contact area between the semiconductor light-emitting element and the bumps 450a may be large, so that the semiconductor light-emitting element is likely to be adsorbed on the partition wall 440 close to the assembly holes 440H1 to 440H3.

In contrast, the bumps 450a located farther from the assembly holes 440H1 to 440H3 may have a relatively small size D21. In this instance, when the semiconductor light-emitting element is located farther from the assembly holes 440H1 to 440H3 during self-assembly, the contact area between the semiconductor light-emitting element and the bumps 450a may be small, so that the semiconductor light-emitting element is less likely to be adsorbed on the partition wall 440 farther from the assembly holes 440H1 to 440H3.

Typically, a plurality of semiconductor light-emitting elements 150R, 150G, and 150B formed as a cluster by the magnet 1100 may be moved in a specific direction. Even if the DEP force is formed in the assembly holes 440H1 to 440H3, it is very difficult to pull only one of the plurality of semiconductor light-emitting elements 150R, 150G, and 150B that are moving by the DEP force and assemble it into the assembly holes 440H1 to 440H3.

However, as in the second embodiment, since the size D21 of the bump 450a located close to the assembly holes 440H1 to 440H3 is greater than the size D21 of the bump 450a located farther from the assembly holes 440H1 to 440H3, it is possible to easily assemble one semiconductor light-emitting element into the corresponding assembly holes 440H1 to 440H3, thereby increasing the assembly rate.

That is, since the semiconductor light-emitting element is likely to be adsorbed on the partition wall 440 near the assembly holes 440H1 to 440H3, and is likely to be adsorbed on the partition wall 440, at least one or more semiconductor light-emitting element may be adsorbed near the assembly holes 440H1 to 440H3. Accordingly, the number of candidate semiconductor light-emitting elements to be assembled in the assembly holes 440H1 to 440H3 may be increased as much as possible, thereby increasing the assembly rate. In this way, when at least one or more semiconductor light-emitting element is adsorbed around the assembly holes 440H1 to 440H3, the adsorbed at least one or more semiconductor light-emitting element may be detached by collision caused by movement of a plurality of semiconductor light-emitting elements 150R, 150G, and 150B having a surrounding cluster unit, and may be assembled in the immediately adjacent assembly holes 440H1 to 440H3, so that the assembly rate can be increased. That is, by increasing the time that the semiconductor light-emitting element stays around the assembly holes 440H1 to 440H3, the probability that the semiconductor light-emitting element is assembled into the assembly hole may be increased, so that the assembly rate can be improved. In addition, at least one or more semiconductor light-emitting element adsorbed around the assembly holes 440H1 to 440H3 can be easily detached by collision caused by the movement of the plurality of semiconductor light-emitting elements 150R, 150G, and 150B having the moving cluster unit. When the at least one or more semiconductor light-emitting element detached in this way is assembled into the assembly holes 440H1 to 440H3, the remaining semiconductor light-emitting elements may no longer be assembled into the assembly holes 440H1 to 440H3 and may be moved by the magnet while being included in the cluster.

Meanwhile, in regions farther from the assembly holes 440H1 to 440H3, the semiconductor light-emitting element may be not adsorbed on the partition wall 440, so that adsorption defects can be prevented.

### [Third Embodiment]

FIG. 25 is a plan view illustrating a self-assembled substrate according to a third embodiment.

As illustrated in FIG. 25, the spacing L1 between the bumps 450a located close to the assembly holes 440H1 to 440H3 may be smaller than the spacing L1 between the bumps 450a located farther from the assembly holes 440H1 to 440H3.

The spacing L1 between the bumps 450a located close to the assembly holes 440H1 to 440H3 may be relatively small. In this instance, when the semiconductor light-emitting element is located close to the assembly holes 440H1 to 440H3 during self-assembly, the contact area between the semiconductor light-emitting element and the bumps 450a may be large, so that the semiconductor light-emitting element is likely to be adsorbed on the partition wall 440 at a location close to the assembly holes 440H1 to 440H3.

In contrast, the spacing L1 between the bumps 450a located farther from the assembly holes 440H1 to 440H3 may be relatively large. In this instance, when the semiconductor light-emitting element is located farther from the assembly holes 440H1 to 440H3 during self-assembly, the contact area between the semiconductor light-emitting element and the bumps 450a may be small, so that the semiconductor light-emitting element is unlikely to be adsorbed on the partition wall 440 at a location farther from the assembly holes 440H1 to 440H3.

As in the third embodiment, since the spacing L1 between the bumps 450a located close to the assembly holes 440H1 to 440H3 is smaller than the spacing L1 between the bumps 450a located farther from the assembly holes 440H1 to 440H3, one semiconductor light-emitting element may be easily assembled into the assembly holes 440H1 to 440H3, thereby increasing the assembly rate.

That is, since the semiconductor light-emitting element is likely to be adsorbed onto the partition wall 440 near the assembly holes 440H1 to 440H3, it is easy to adsorb onto the partition wall 440, and thus at least one or more semiconductor light-emitting element may be adsorbed near the assembly holes 440H1 to 440H3. Accordingly, the number of candidate semiconductor light-emitting elements to be assembled into the assembly holes 440H1 to 440H3 may be increased as much as possible, thereby increasing the assembly rate. In this way, when at least one or more semiconductor light-emitting element is adsorbed around the assembly holes 440H1 to 440H3, the adsorbed at least one or more semiconductor light-emitting element may be detached by collision caused by movement of a plurality of semiconductor light-emitting elements 150R, 150G, and 150B having a surrounding cluster unit and assembled into the immediately adjacent assembly holes 440H1 to 440H3, so that the assembly rate can be increased.

Meanwhile, in regions farther from the assembly holes 440H1 to 440H3, the semiconductor light-emitting elements may be not adsorbed onto the partition wall 440, so that adsorption defects can be prevented.

### [Fourth Embodiment]

FIG. 26 is a cross-sectional view illustrating a self-assembled substrate according to a fourth embodiment.

The fourth embodiment is the same as the first embodiment except for the dielectric capping layer 455. In the fourth embodiment, components having the same shape, structure, and/or function as those in the first embodiment are given the same drawing reference numerals and detailed descriptions are omitted.

Referring to FIG. 26, the self-assembled substrate 404 according to the fourth embodiment may comprise a substrate 410, a first assembly wiring 421, a second assembly wiring 422, a partition wall 440, a first non-uniform layer 450, and a dielectric capping layer 455.

The dielectric capping layer 455 may be disposed on the partition wall 440. The dielectric capping layer 455 may not be disposed in the assembly hole 440H1.

The dielectric capping layer 455 may not be disposed on a bottom surface of the assembly hole 440H1. Since the dielectric capping layer 455 functions as a super-hydrophilic surface-modified layer, it may hinder the absorption of the semiconductor light-emitting element during self-assembly. The bottom surface of the assembly hole 440H1 is a site where the semiconductor light-emitting element is settled and fixed by the DEP force, and the semiconductor light-emitting element assembled in the assembly hole 440H1 should not fall out of the assembly hole 440H1, so that the assembly rate can be increased and lighting defects can be prevented. Accordingly, since the dielectric capping layer 455 is not disposed on the bottom surface of the assembly hole 440H1, the fixation with the semiconductor light-emitting element on the bottom surface of the assembly hole 440H1 may be strengthened, thereby increasing the assembly rate and preventing lighting defects.

Meanwhile, when the semiconductor light-emitting element is adsorbed on the inner side of the assembly hole 440H1, the semiconductor light-emitting element is not correctly located on the bottom surface of the assembly hole 440H1 but is tilted or slanted, which may cause a short circuit during electrical connection in a post-process, resulting in lighting defects. Therefore, since the inner side of the assembly hole 440H1 should be such that adsorption is prevented, the dielectric capping layer 455 may be disposed on the inner side of the assembly hole 440H1 as in the fourth embodiment. Accordingly, the semiconductor light-emitting element assembled in the assembly hole 440H1 by the dielectric capping layer 455 on the inner side of the assembly hole 440H1 may be not adsorbed on the inner side of the assembly hole 440H1, but may be adsorbed or fixed on the bottom surface of the assembly hole 440H1, so that the assembly rate can be increased and lighting defects can be prevented.

### [Fifth embodiment]

FIG. 27 is a cross-sectional view illustrating a self-assembled substrate according to a fifth embodiment.

The fifth embodiment is the same as the first to fourth embodiments except for the second non-uniform layer 457. **In** the fifth embodiment, components having the same shape, structure, and/or function as those of the first to fourth embodiments are given the same drawing reference numerals, and detailed descriptions are omitted.

Referring to FIG. 27, the self-assembled substrate 405 according to the fifth embodiment may comprise a substrate 410, a first assembly wiring 421, a second assembly wiring 422, a partition wall 440, a first non-uniform layer 450, a second non-uniform layer 457, and a dielectric capping layer 455.

The second non-uniform layer 457 may be disposed on the first non-uniform layer 450. The second non-uniform layer 457 may be disposed between the first non-uniform layer 450 and the dielectric capping layer 455.

The second non-uniform layer 457 may have a third uneven structure 458. **In** this instance, the third uneven structure 458 may be a nanotexture. The width of the pattern of the nanotexture or the gap between the patterns may be several nanometers, for example, 3 nm or less.

The second non-uniform layer 457 may be disposed at an upper surface of each of the plurality of bumps 450a of the first non-uniform layer 450. The second non-uniform layer 457 may be disposed at the partition wall 440 between the plurality of bumps 450a of the first non-uniform layer 450.

After the first non-uniform layer 450 comprising the plurality of bumps 450a is disposed on the partition wall 440, an ashing process using O2 plasma may be performed, thereby forming the second non-uniform layer 457 having the third uneven structure 458, which is a nano-texture. That is, when the ion particles of the O2 plasma collide with the upper surface of the partition wall 440 and the upper surface of the bump 450a, surface roughness may be formed at the upper surface of the partition wall 440 and the upper surface of the bump 450a, and this surface roughness may be formed as a nanotexture.

Even if an ashing process using O2 plasma is performed on the overall region of the substrate 410, the insulating layer 430 within the assembly hole 440H1 is an inorganic material and does not react to the O2 plasma, so that the second non-uniform layer 457 may not be formed on the insulating layer 430. When the insulating layer 430 is an organic material, the second non-uniform layer 457 having a nanotexture may be formed on the upper surface of the insulating layer 430 within the assembly hole 440H1.

The fifth embodiment may further reduce the possibility of absorption of the semiconductor light-emitting element during self-assembly by arranging the second non-uniform layer 457 on the first non-uniform layer 450 together with the first non-uniform layer 450, and may further enhance the function as an external light-scattering layer together with the dielectric capping layer 455.

Meanwhile, the display device described above may be a display panel. That is, in the embodiment, the display device and the display panel may be understood to have the same meaning. In the embodiment, the display device in a practical sense may comprise a display panel and a controller (or processor) that may control the display panel to display an image.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

### [Industrial Applicability]

The embodiment may be adopted in the display field for displaying images or information. The embodiment may be adopted in the display field for displaying images or information using a semiconductor light-emitting element. The semiconductor light-emitting element may be a microlevel semiconductor light-emitting element or a nano-level semiconductor light-emitting element.

For example, the embodiment may be adopted in a TV, a signage, a mobile terminal such as a mobile phone or a smart phone, a computer display such as a laptop or a desktop, a head-up displays (HUD) for an automobile, a backlight unit for display, a display for extended reality (XR) such as AR, VR, and mixed reality (MR), a light source, etc.

## Claims

1. A self-assembled substrate, comprising:
a substrate;
a first assembly wiring on the substrate;
a second assembly wiring on the substrate;
a partition wall having an assembly hole on the first assembly wiring and the second assembly wiring;
a first non-uniform layer having a first uneven structure on the partition wall; and
a dielectric capping layer having a second uneven structure on the partition wall,
wherein the second uneven structure has a shape corresponding to a shape of the first uneven structure.

2. The self-assembled substrate of claim 1, wherein the dielectric capping layer is a super-hydrophilic surface-modified layer.

3. The self-assembled substrate of claim 1, wherein the dielectric capping layer is a protective layer.

4. The self-assembled substrate of claim 1, wherein the dielectric capping layer is an external light-scattering layer.

5. The self-assembled substrate of claim 1, wherein the first non-uniform layer comprises a plurality of bumps, and
wherein the plurality of bumps are disposed on an upper surface of the partition wall.

6. The self-assembled substrate of claim 5, wherein a size of the bumps is smaller than a size of a semiconductor light-emitting element.

7. The self-assembled substrate of claim 5, wherein a spacing between the bumps is smaller than a size of a semiconductor light-emitting element.

8. The self-assembled substrate of claim 5, wherein a size of each of the plurality of bumps or a spacing between the plurality of bumps are different depending on a separation distance from the assembly hole.

9. The self-assembled substrate of claim 8, wherein a size of the bump located closer to the assembly hole is greater than a size of the bump located farther from the assembly hole.

10. The self-assembled substrate of claim 8, wherein a spacing between the bumps located closer to the assembly hole is smaller than a spacing between the bumps located farther from the assembly hole.

11. The self-assembled substrate of claim 5, wherein the dielectric camping layer is disposed on the upper surface of the partition wall excluding the assembly hole.

12. The self-assembled substrate of claim 11, wherein the dielectric capping layer is disposed on an inner side of the assembly hole.

13. The self-assembled substrate of claim 5, comprising a second non-uniform layer having a third uneven structure on an upper surface of each of the plurality of bumps.

14. The self-assembled substrate of claim 13, wherein the second uneven layer is disposed on the upper surface of the partition wall between the plurality of bumps.

15. The self-assembled substrate of claim 13, wherein the third uneven structure is a nanotexture.

16. The self-assembled substrate of claim 1, wherein the self-assembled substrate is an interposer substrate or a backplane substrate.

17. A display device manufactured using the self-assembled substrate according to claim 1.
